(19)

**Europäisches Patentamt**

**European Patent Office**

**Office européen des brevets**

(11)  **EP 4 280 273 A1**

(12)  **EUROPEAN PATENT APPLICATION**

(43) Date of publication:
**22.11.2023  Bulletin 2023/47**

(21) Application number: **22305748.0**

(22) Date of filing: **19.05.2022**

(51) International Patent Classification (IPC):
**H01L 23/485** (2006.01)       **H01L 23/31** (2006.01)
**H01L 21/60** (2006.01)

(52) Cooperative Patent Classification (CPC):
(C-Sets available)
**H01L 24/05; H01L 23/3142; H01L 24/03;**
H01L 24/45; H01L 24/48; H01L 2224/0331;
H01L 2224/0347; H01L 2224/03602;
H01L 2224/0361; H01L 2224/0362;
H01L 2224/0384; H01L 2224/04042;
H01L 2224/05017; H01L 2224/05124;
H01L 2224/05559;                    (Cont.)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Mitsubishi Electric R&D Centre Europe B.V.
1119 NS  Schiphol Rijk Amsterdam (NL)**
Designated Contracting States:
**FR**
• **Mitsubishi Electric Corporation
Tokyo 100-8310 (JP)**
Designated Contracting States:
**AL AT BE BG CH CY CZ DE DK EE ES FI GB GR
HR HU IE IS IT LI LT LU LV MC MK MT NL NO PL
PT RO RS SE SI SK SM TR**

(72) Inventor: **PICHON, Pierre-Yves
35708 RENNES CEDEX 7 (FR)**

(74) Representative: **Plasseraud IP
66, rue de la Chaussée d'Antin
75440 Paris Cedex 09 (FR)**

(54)  **SEMICONDUCTOR CHIP COMPRISING STRUCTURED METALLIZATION WITH INCREASED RELIABILITY, AND MANUFACTURING METHOD**

(57)    The present disclosure relates to a semiconductor chip, having an aluminium layer, wherein said aluminium layer has a structuration of at least a portion of a surface receiving an additional deposition (Cu), and wherein said structuration forms peaks on said portion of surface occupying between 20 and 80% of said portion of surface.

*State of the art*    *Proposed solution*

**FIG. 11**

**EP 4 280 273 A1**

(52) Cooperative Patent Classification (CPC): (Cont.)
H01L 2224/05647; H01L 2224/45124;
H01L 2224/45147; H01L 2224/4847;
H01L 2924/18301; H01L 2924/3512;
H01L 2924/3656

C-Sets
H01L 2224/45124, H01L 2924/00014;
H01L 2224/45147, H01L 2924/00014

## Description

The present description relates to a top interconnection of an electronic device and a method for manufacturing it.

Interconnection technologies for power electronic devices generally include a so-called "top interconnection" having the function of connecting electrically a semiconductor device to a metallic lead frame.

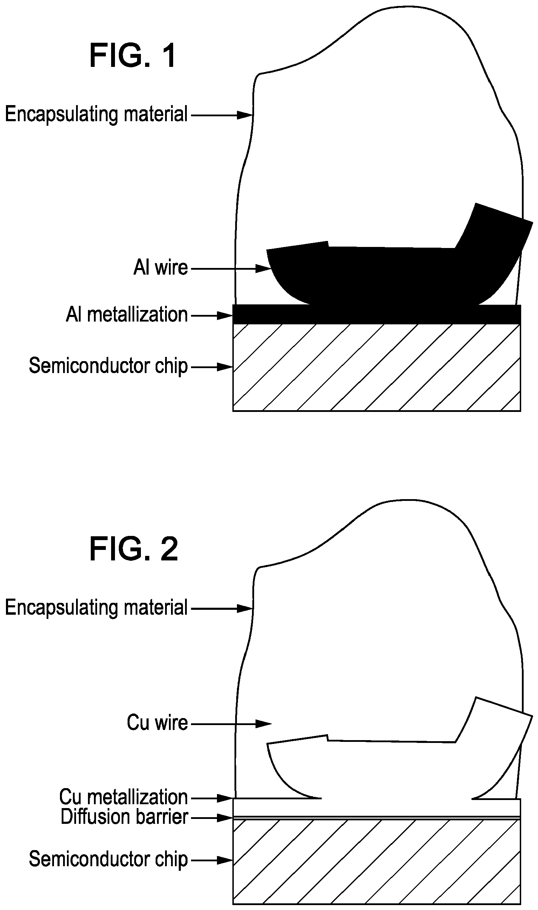

State of the art interconnection technologies for top interconnections can include aluminium-based interconnections, and as presented in the example of figure 1, can comprise:

◦ A metallization layer of aluminium (Al) or alloys thereof (with less than 5%Cu and/or 5%Si), of thickness typically between 2 and 10μm. This layer is generally delivered together with the chip by semiconductor chip manufacturers and is deposited on areas on the top surface of the semiconductor chips. State of the art processes to deposit metallic layers selectively on some areas of the silicon chip are photolithographic processes based on subtractive transfer or additive transfer:

◦ In a subtractive transfer process:

▪ First, a continuous film of homogeneous thickness of metal is deposited using deposition methods, typically a Physical Vapor Deposition method such as sputtering or evaporation.
▪ Then, an etch resist layer is deposited on the metal surface except where the metal layer is unwanted. This is typically done using a photolithographic process.
▪ Finally, the exposed metal surfaces are removed using wet etching and the etch resist layer is removed

◦ In an additive transfer process:

▪ First one, or two etch resist layers are deposited selectively on the surfaces where a metal layer is not wanted.
▪ Then, a homogeneous layer of metal is deposited over both the etch resist layer and the final metallization surfaces.
▪ Finally, the etch resist layer is removed, resulting of the peel-off of the metal layer from the unwanted surface.

◦ Aluminium wires (or ribbons) connected between the aluminium metallization and the lead frame. This interconnection is typically made by power module manufacturers during the assembly of the power module. A process according to the state of the art for connecting the aluminium wires and form bonds with the aluminium metallization is a so-called "ultrasonic bonding" process, where a wire is attached to the metallization using ultrasonic energy and pressure to promote deformation and interdiffusion of the metallization and of the wire in the solid-state (no melting). Note that more reliable bonds are typically formed when contacted with a flatter aluminium surface.

Aluminium-based interconnection is the standard technology used currently in the industry. However, a transition from aluminum to copper interconnection technology is beneficial for several reasons:

o Copper wire bonding is seen as next-generation top interconnection packaging solution, giving the opportunity to achieve reliable bonds at higher maximum operating temperature. Several manufacturers have shown significant reliability improvements of Cu-based interconnection compared to aluminum-based interconnections (typically a factor 10 increased interconnection life), due to a more stable wire-bond;
◦ Better compatibility with higher bandgap chip materials (SiC and GaN) which can operate at higher temperature;
◦ Higher current carrying capability, thus compatibility with high current density devices (Si-based devices or high bandgap semiconductors devices);
◦ Higher short circuit protection, during the turn-off event in high frequency Pulse Width Modulation (PWM) operation. Compared to classical aluminum-based metallization, the higher heat capacity of Cu, combined with a higher metallization thickness, can provide a higher heat buffer to prevent overheating of the chip during high frequency thermal events, and thus increase the short circuit reliability of the package;
o Compatibility with standard PCB technologies, thus enabling the embedding of power electronic dies into PCB boards with the added benefits of lower parasitic capacitance and lower thermal impedance.

On the other hand, the state-of-the art copper-based interconnections, can usually comprise, in a first embodiment as presented in the example of figure 2:

◦ A diffusion barrier to prevent copper to diffuse into the semiconductor device, react with and alter its electronic performance. This diffusion barrier can be a thin layer of tantalum (Ta) or tantalum nitride (TaN), Titanium (Ti), or Titanium nitride (TiN), W, deposited by sputtering or chemical vapor deposition. Diffusion barrier layers are typically deposited by chip manufacturers. These diffusion barrier layers do not consist in Aluminium and thus require a not standard, but specific process implemented by chip manufacturers. Currently such chips are not widely available to module manufacturers.

◦ A copper metallization layer, with thickness typically more than 10μm, typically deposited by an electrolytic process (electroplating).

◦ Thick (>250μm) copper wires connected to the metallization layer, using ultrasonic wedge bonding.

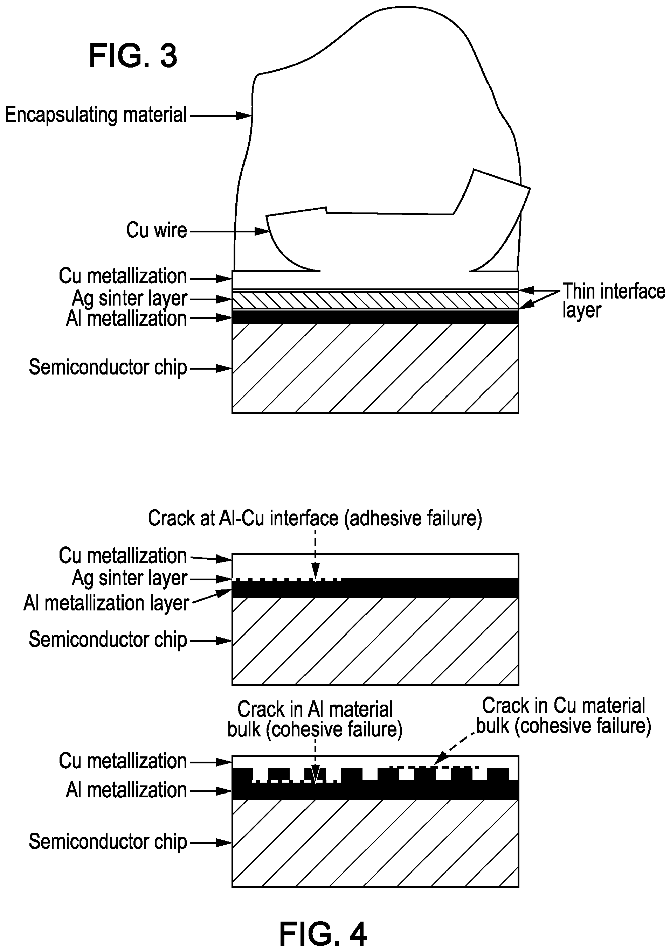

Other state-of-the art copper-based interconnections, as shown in the example of figure 3, can include:

◦ The standard aluminium metallization layer, deposited by sputtering for example. Thus, in this case standard chips can be used by module manufacturers;

o An Ag sinter layer deposited by a pressure-based or pressure-less process, between the chip and the copper layer;

o A copper foil attached to the Ag sinter layer during the sintering process;

o Thick (>250μm) copper wires connected to the metallization layer, using ultrasonic wedge bonding.

From the preceding description of the state of the art, it is thus clear that the copper wire-bonding technology is superior to the aluminium wire-bonding technology in several aspects. However, both state-of-the art solutions have issues:

- in the solution shown in figure 2, the deposition of the thin diffusion barrier on top of the semiconductor chip is a non-standard process and is currently not widely used in the industry, making such chips with copper metallization not widely available to power module manufacturers,

- in the solution shown in figure 2, the deposition of the thin diffusion barrier on top of the semiconductor chip is an additional costly manufacturing step. Additionally, the process is critical, since high cleanness and homogeneity is required for the diffusion barrier to work effectively,

- in the solution shown in figure 3, where the standard Al-metallization is used in a copper-based top interconnection, the failure of the aluminium layer and thus the delamination at between the semiconductor and the Ag sinter layer limits the lifetime of the module. The failure occurs due to a crack propagation within the aluminium top metallization layer. This is shown in figure 3, between the Si IGBT layer and the Ag sinter on top layer.

- Moreover, in the solution shown in figure 3, an Ag layer is used to connect the aluminium metallization with the copper layer. The choice of an Ag layer is primarily driven by the reliability of Ag-sintered interconnections and the availability of this technology. However, introducing this connection adds a process step requiring typically a costly time and energy consuming thermal treatment step in the product manufacturing.

Thus, to overcome the limitations described above, it is desirable to connect a copper layer directly onto an aluminium layer. However, it is difficult to create a reliable Cu-Al interface because the adhesive strength of Cu on Al may be poor. The adhesive failure of Al-Cu bonds is due to several factors, which can be classified as either extrinsic or intrinsic:

◦ Extrinsic factors: the thermo-mechanical stresses generated at the Al-Cu interface is the driving force for adhesion failure of the bond. Temperature variations during product manufacturing and during product usage generate stresses at the joints due to the different thermal expansion coefficients of the materials present in the layer stack assembly. In semiconductor-interconnection material layer geometries where the metallization layers are thin compared to the semiconductor die thickness, stresses are strongest at the edges of the die and are mostly of shear nature (called usually "mode II loading");

◦ Intrinsic factors:

▪ Native oxide layer: both aluminium and copper readily form an oxide layer when exposed to air. This can prevent the formation of strong metallic bonds at the atomic scale and therefore significantly reduce the adhesion strength. For this reason, during manufacturing of an Al-Cu bond by chemical or electrochemical methods (electroless or electroplating) for example, the oxide layer is often removed, and the surface is protected from further oxidation by the deposition of a nanometre scale layer (so-called "passivation layer") or coated by a barrier layer of typically less than 2μm.

▪ Reaction between Al and Cu during high temperature exposure. Cu and Al form intermetallic phases that are mechanically weak and more susceptible to oxidation and corrosion. Additionally, the reaction involves volume change which can generate cracks even without thermomechanical stresses, or voids ("Kirkendal voiding"). For this reason, a thin, non-reactive interfacial coating layer (typically less than 2μm) is also beneficial.

Despite the use of interfacial coatings or passivation layers, the adhesive strength between Al and Cu may not be sufficient to provide a bond with reliability at least comparable to the state of the art. The first problem addressed by the present disclosure is thus the poor adhesive strength between Al and Cu, preventing to generate reliable Al-Cu bonds.

Moreover, in a classical power module, the power semiconductor chips are typically protected from the environment by an encapsulating compound, which is typically poured as a heated liquid at the end of the packaging process, and further solidified after cooling. The functions of this encapsulating compound are to:

- Protect the chip and its interconnections from dust, oxidation and corrosion.
- Prevent electrical breakdown between electrical connection elements separated with a high voltage difference.

Thus, the required properties of encapsulating compounds are a high isolation value, and low moisture absorption and diffusion rate. Additionally, the thermomechanical properties of these materials should be such as no additional thermomechanical stress is applied to the critical packaging elements, such as the top aluminum interconnection.

State of the art encapsulating compounds can be divided into:

- Silicon gel type materials, which generally provide sufficiently high breakdown voltage and can be used under a wide temperature range (generally -50 to 200°C). Having flexible mechanical properties, they have negligible impact of the thermo-mechanical stress of the assembly;
- Epoxy-based potting compounds, which provide a generally better isolation value than silicon gel materials, therefore they are seen as the next generation isolation material for high voltage power modules. However due to their higher elastic limit and high coefficient of thermal expansion, stresses can be generated at the interfaces between the semiconductor die and the encapsulation material.

It may be desirable to use epoxy-based encapsulating material for protection of the electronic assembly against dust, corrosion, and moisture, because these materials may be more appropriate than silicon gels in harsh environments and high voltage applications. However, due to their higher elastic strength and hardness, combined with a high coefficient of thermal expansion, stresses may be generated at the interface between the semiconductor device and the epoxy, resulting in delamination by adhesive failure.

This second problem related to the poor adhesive strength between Al and the epoxy-based encapsulating material, prevents to generate a reliable bond between the metallization and the epoxy. Failure can occur during processing or during product usage due to (cyclic) temperature exposure (for example during solder reflow, power cycles) and when the thermal (or hygrothermal) stresses overcome the adhesion strength of the bond. Build-in of vapor pressure in initially small interfacial pores can increase interfacial stresses and result in failure of the encapsulating material ("pop-corn" effect). The net result of the presence of a gas layer of low isolation may be the failure of the power electronic system through electrical breakdown at high voltage.

The present description aims to improve the situation caused at least by the two problems presented above.

To that end, it proposes a semiconductor chip, having an aluminium layer, wherein said aluminium layer has a structuration of at least a portion of a surface receiving an additional deposition, and wherein said structuration forms peaks on said portion of surface occupying between 20 and 80% of said portion of surface.

As presented in examples of embodiments below, such a structuration forms an interlock structure with the additional deposition and shear adhesive strength between the aluminium layer and the additional deposition assembled to it is increased. The reliability of the assembly is thereby improved.

In an example of embodiment, the aluminium layer is a metallization layer having typically a mean thickness T between $2\mu$m and $15\mu$m.

In an example of embodiment, the aluminium layer having a mean thickness T, the structuration has a length L, measuring a mean distance between first neighbour peaks of the structuration, and being related to said mean thickness T by L<10*T.

In an example of embodiment, the aluminium layer having a mean thickness T, the structuration has a depth D, measuring a mean depth D of said peaks, and being related to said mean thickness T by D>0.2*T.

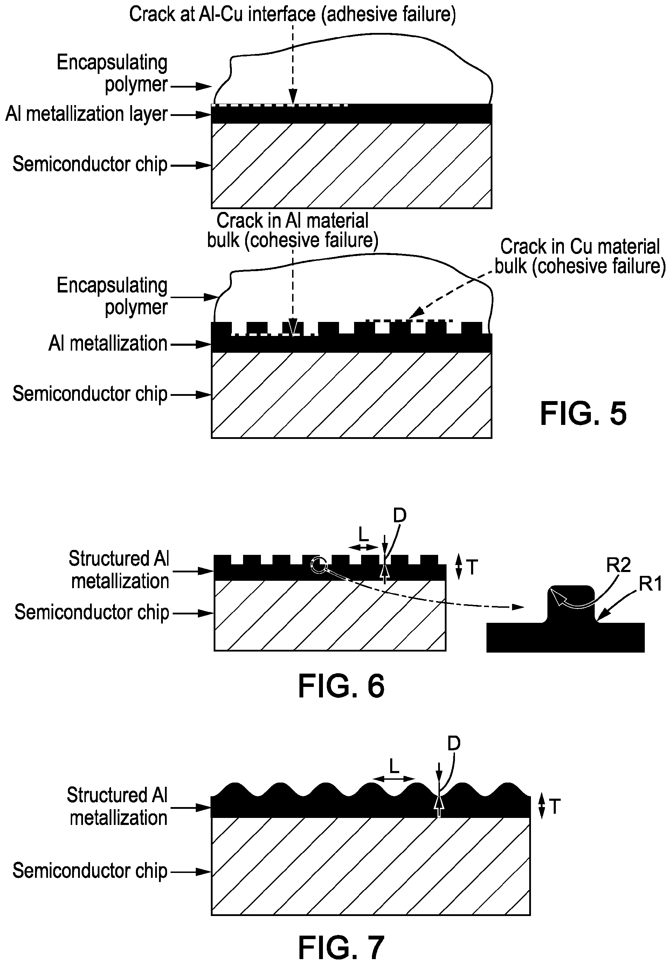

In an example of embodiment, the peaks can form a periodic sinusoidal shape in at least one profile section of said structuration (as shown in figure 7 commented below).

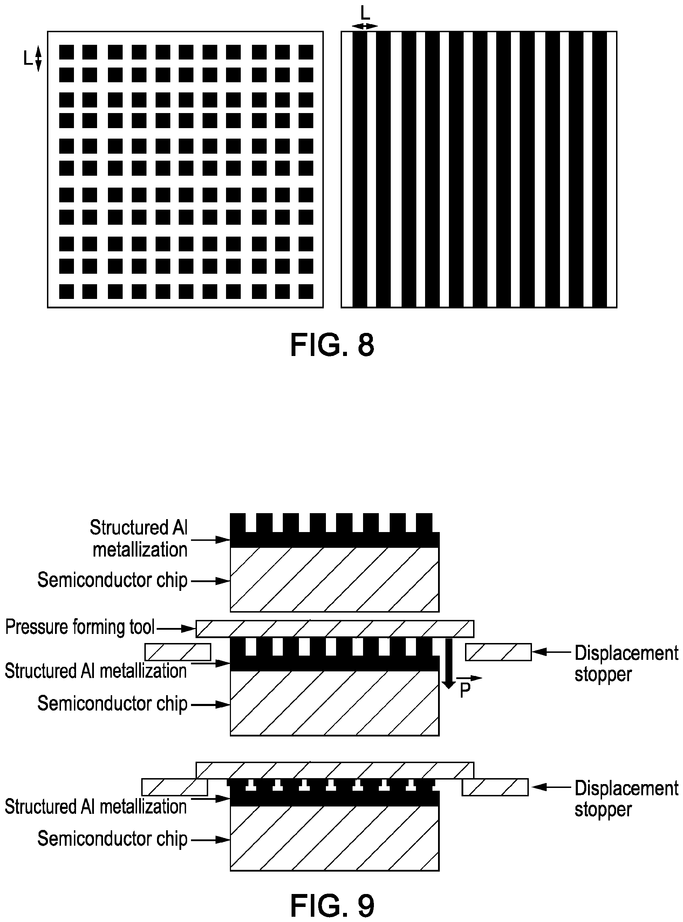

In an example of embodiment, the peaks have a bulge at their top (as shown in figure 9 commented below).

The aforesaid semiconductor chip can be for example a power semiconductor chip.

At least in this kind of application, the additional deposition can comprise copper or can comprise an epoxy resin.

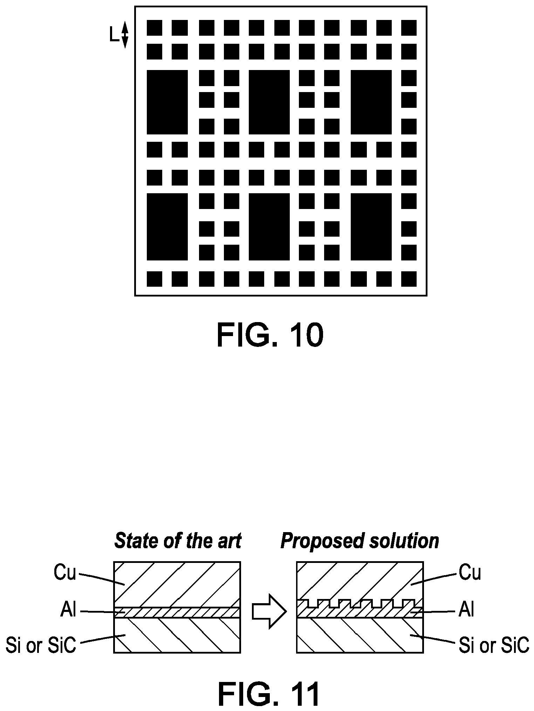

Moreover, the surface of the aluminium layer can comprise at least one additional portion distinct from said portion comprising the structuration, which can be configured for an electrical connection of said aluminium layer (as shown in figure 10 commented below).

The present disclosure aims also at a method for manufacturing a semiconductor chip having an aluminium layer, the method comprising:

- depositing said aluminium layer,
- forming a structuration on at least a portion of a top surface of said aluminium layer, and
- forming an additional deposition at least on said portion,

wherein said structuration forms peaks on said portion occupying between 20 and 80% of said portion.

In an example of embodiment, forming said structuration can comprise:

- a spatially selective deposition of a mask on said portion, said mask avoiding an etching effect of the aluminium layer underneath the mask,
- etching said portion, and
- removing the mask ;

and/or, in combination or alternatively:

- a spatially selective deposition of a mask on said portion, said mask avoiding a deposition of aluminium on the mask,
- depositing aluminium on the portion, and
- removing the mask.

Alternatively or in combination, forming said structuration can comprise a use of a machining tool to deform the top surface of said portion and create said peaks.

In an embodiment, forming said structuration can further comprise applying a pressing tool on the top of said peaks to form bulges therein.

More details are presented in the specification below, with reference to the appended drawings where:

- Figure 1 shows an aluminium-based top interconnection of a semiconductor chip according to the state of the art,
- Figure 2 shows a first type of copper-based top interconnection according to the state of the art (solution "A"),
- Figure 3 shows a second type of copper-based top interconnection according to the state of the art (solution "B"),
- Figure 4 shows a problem occurring due to poor adhesion strength of Cu-Al interface (top), and the proposed solution of mixed cohesive/adhesive failure mode (bottom), in an example of embodiment,
- Figure 5 shows a problem occurring due to poor adhesion strength of Cu-encapsulating polymer (top), and the proposed solution of mixed cohesive/adhesive failure mode (bottom), in an example of embodiment,
- Figure 6 shows a cross section view of an example of a structured aluminium metallization having more particularly a pillar structure with stress risers,
- Figure 7 shows a cross section view of an example of a structured aluminium metallization having more particularly a periodic sinusoidal shape in at least one direction,
- Figure 8 is a top view of an example of structured aluminium metallization, where black regions designate the area fraction exposed to the structuration forming,
- Figure 9 shows an example of overhang structures by applying a pressure having the direction of vector P,
- Figure 10 shows an example of portions of the aluminium layer surface which are put aside to create therein electrical contacts to connect the aluminium layer,
- Figure 11 shows a comparison between a semiconductor chip (Si or SiC chip) comprising an aluminium layer according to the prior art (left) and same semiconductor chip comprising a structured aluminium layer according to the present disclosure.

This embodiment makes it possible to circumvent the issue of poor adhesive strength of Cu-Al interfaces described above, by providing a specific geometry of a non-flat structured interface between the Al metallization and the Cu metallization.

Below, by "Al-Cu interface", it is meant the joint between the semiconductor die aluminium metallization and a copper layer fixed to this metallization. There may be additional thin layers at the interface between the Al and the Cu layer (for the purpose of oxide removal for example during manufacturing, or corrosion/oxidation prevention during product usage) but in what follows these layers are considered part of the joint because their thickness is smaller (usually less than $2\mu m$ for each layer) compared to the aluminium or the copper metallization thickness.

Additionally, this embodiment makes it possible to circumvent the issue of poor adhesive strength of Al-potting compound interfaces described above by using the non-flat structured aluminium metallization surface.

The effect of adopting a structured metallization surface is to generate an interlock structure between the aluminium metallization and the material assembled to it, be it:

- a copper layer used for high reliable copper-based interconnection
  or

- a polymer (for example an epoxy-based resin) used as encapsulating material.

Interlock structures are particularly efficient to avoid adhesive failure in cases where shear stresses dominate at or close to the interface, which is usually the case for semiconductor die packaging material interfaces. A more reliable bond is created when using a structured interface because the strength of the interface is increased due to the presence of an interlock structure, which enables additional plastic or viscoelastic energy dissipation on the bulk of the material, away from the interface as shown in figure 4 (for the implementation of Cu-Al interface) and figure 5 (for the implementation of the Cu-encapsulating polymer) presented below:

- Without interlock structure (top drawing of figure 4), the Al-Cu interface or the Al-polymer interface fails adhesively due to the poor adhesive strength of the assembly: cracks propagate mostly at the interface,

- In presence of an interlock structure (bottom drawing of figure 5), the interface fails in a mixed mode of adhesion/ cohesion: crack propagate both at the interface of the assembly and within the bulk. Since the physical bonding is stronger within the bulk than at the interface, a more reliable bond is thereby generated.

The same effect can be seen on figure 5 related to the Al-polymer encapsulation.

It can be noticed then that structuration of the aluminium layer can be implemented in several situations, such as for the deposition of the copper layer, or the resin layer, adjacent to the structured surface of the aluminium layer. Of course, such a structuration can be implemented in other situations (for depositing a silver layer, for example).

Therefore, the present disclosure can aim at a semiconductor chip, having an aluminium layer, wherein said layer comprises a structuration of a surface receiving an additional deposition (be it a resin layer or a cupper layer, etc.). More particularly, said structuration forms peaks on said surface occupying between 20 and 80% of said surface.

In other words, an exposed area fraction A, measuring the area made by higher spots (or "peaks") of the structure, is preferably in the range 20%<A<80%, more preferably in the range 30%<A<70%, and more preferably in the range 40%<A<60%, *i.e.* around 50% for example.

The aforesaid semiconductor chip can be more particularly a power semiconductor chip.

The aluminium layer can be more particularly a metallization layer.

In an example of embodiment, with an aluminium layer having a mean thickness T, the structure can have a length L, measuring the mean distance between neighbour peaks of the structure, related to the mean layer thickness by L<10*T.

In an example of embodiment, with an aluminium layer having a mean thickness T, the structure can have a depth D, measuring the mean depth of the structure, the characteristic depth being related to the mean metallization thickness by D>0.2*T.

Thus, the shear adhesive strength between the metallization and materials assembled to it is increased, and the reliability of the assembly is thereby improved.

Examples are given below.

By 'Aluminium', it is meant below an aluminium material with a minor amount of impurities, either dissolved or precipitated. For example, the aluminium may have a purity of 6N (99.9999% pure) or 3N (99.9%) the remaining elements being intentionally or not intentionally present in the material to tune its mechanical, electrical properties, or its properties against electromigration. In another example, impurities are intentionally added to the material to improve its mechanical, electrical properties, or its properties against electromigration. For example, less than 1% of silicon and/or less than 1% of copper is added to increase the material hardness or strength, and/or to reduce electromigration.

In one example of embodiment, the aforesaid "at least a portion of the metallization" is the full surface of the metallization. In embodiments below where parts of the metallization layer are to be connected (for example through wire bonds), such parts may not be structured.

In one example of embodiment, the structure has the following characteristics:

- The mean metallization thickness T is in the range of $2\mu m$-$15\mu m$, preferably in the range $3\mu m$-$8\mu m$, for example $5\mu m$
- The characteristic length L is in the same order of magnitude as the metallization thickness, for example L=3*T, or preferably L=2*T, or for example L=T, for example $L=5\mu m$.
- The characteristic depth D is a significant portion of the metallization thickness, for example more than 20% of the metallization thickness, preferably more than 50% of the metallization thickness, for example $3\mu m$
- The area fraction A is between 30% and 70%, or even between 40% and 60%, or even it is 50%.

In this example, when the aluminium metallization is then attached to a neighbour material forming an interface with poor adhesive strength, a shear stress applied to this interface is distributed towards the bulk of the aluminium metallization and that of the neighbour material, thereby advantageously reducing the risk of adhesive failure between the two materials.

The dimension D may be repeatable or may exhibit a significant variation on the metallization surface, depending on the manufacturing process. For example, the dimension D may vary between 5% of the metallization thickness and 50% of the metallization thickness, in a regular or in a random manner.

Example structures consist in discrete elevated hills arranged in square patterns or in ridges pattern (examples of figures 6 and 7), and can also consists in elevated hills arranged in a hexagonal pattern, or any periodic arrangement. Alternatively, the structure may consist in isolated hills or ridges separated by a varying distance L, i.e. in a randomly distributed manner, such as the structure may also not be periodic. For example, the distance L may vary between 0.1D and 10D, preferably between 0.5D and 2D, where D is the mean depth.

A characterization of the structure (measurement of D, L and T) can be done using the following measurement tools and methods:

- A profilometer, which measures the height of a profile (2D) or of a surface (3D), such as a mechanical profilometer, or an optical profilometer, and

- Cross-sectioning through the semiconductor die and the metallization using standard microsection sample preparation techniques (cutting, mirror polishing) and subsequent observations using a microscope, possibly combined with image analysis tools to extract a profile of the semiconductor-metallization interface.

The profiles should be analysed using the following data processing methods:

- Measurement of T: distance between semiconductor-aluminium interface and the mean height of the aluminium metallization, using the microsection microscopy image.
- For regular surface structures where L and D can be unambiguously determined, direct measurements can be carried out from the surface profile without the need for statistical analysis tools.
- For a structure with significant statistical variation in structure size:

  ○ measurements of D can be done using the mean arithmetic average of the profile: average roughness Ra (for 2D measurement) or Sa (for 3D measurements) and using the formula D=2*Ra, or D=2*Sa, respectively (ISO4287:1997).
  ○ the length L can be measured using the mean width parameters PSm, RSm, WSm (ISO4287:1997).
  ○ The area fraction A can be measured using the Rpk parameter according to ISO 13565-2, or by the Spk parameter according to ISO 13565-3, the Rpk and Spk parameters being evaluated at the areal material ratio value of A.

In an embodiment, the structure is prevented from stress risers, or, in other words, its shape is chosen so as to minimize the presence of stress risers. By stress risers it is meant the presence of sharp corners at the structure which will act as stress concentration centres at the metallization and at the material deposited onto it. It is generally accepted that the stress $\sigma_R$ at a sharp corner of radius R inversely proportional to the value of the square root of the radius R and is related to the remote stress intensity $\sigma$ by:

$$\sigma_R = \frac{f(geometry, stress\ mode\ etc\ ...)}{\sqrt{R}}$$

Thus, for example, referring to the right part of figure 6, the stress in the neighbourhood of the corners of radius R1 and R2 is increased as R1 and R2 decreases, and cohesive failure can then start at these points.

Therefore, in an advantageous embodiment, it can be chosen to maximize the radius of curvature of the structure, as presented in the example shown in figure 7, where the maximum radius approaches D. For example, a cross section of the structure gives an interface that preferably approaches a sinusoidal wave with a period 2D and an amplitude D.

The profile taken along one single direction can have a periodic shape (as presented in the right part of figure 8) or even the profile taken along two perpendicular directions of the structured surface can have periodic hill shapes surrounded by valley shapes (as presented in the left part of figure 8).

The present description can aim also at a method for structuring the aluminium metallization layer, comprising for example the following:

- Patterning a wafer using standard metallization techniques using a subtractive transfer process or an additive transfer process, in view to obtain a continuous layer of aluminium of thickness T+D, at defined positions on the semiconductor chip, and
- Selectively removing a thickness in two directions at defined regions of the aluminium layer using a subtractive transfer process.

Thus, advantageously, the structure can be added on standard semiconductor chips with standard aluminium metallization. Module manufacturers can easily implement the present process on any standard aluminium metallization.

The subtractive transfer process can include lithographic processes, and follow for example the following steps:

○ First, a continuous film of homogeneous thickness of metal is deposited using deposition methods, such as a Physical Vapor Deposition method (PVD), chemical vapor deposition method (CVD), or a (electro)plating method,
○ Then, an etch resist layer is deposited on the metal surface except where the metal layer is unwanted. This is typically carried out by using a photolithographic process.
○ Finally, the exposed metal surfaces are removed using wet etching and the etch resist layer is removed.

PVD methods can include evaporation and RF sputtering methods.

Instead of etching, mechanical processes can be implemented such as grinding, sand blasting, chemically aided mechanical polishing (CMP), or others, which use large particle sizes (i.e. larger than the usual state of the art) so as to obtain the non-square structure presented in figure 6 or figure 7.

Another alternative to the etching is an inhomogeneous chemical process such as an inhomogeneous etching because of a random nature of the etching process (such as a pitting corrosion process).

Alternatively of in combination, a part of the aluminium can be removed using plasma etching process.

Alternatively of in combination, aluminum can be added using a screen-printing process only at the raised positions of the structure, and the structure can be subsequently subjected to a thermal treatment to provide a structure with mechanical strength comparable to that of bulk aluminum.

More generally, the aluminium metallization layer can be structured by selectively adding a thickness of aluminium at defined regions of the firstly deposited aluminium layer (using typically an additive transfer process). An example of an additive transfer process can consist of:

- Depositing at least one etch resist layer selectively on the surfaces where the aluminium layer should not be deposited,
- Then, a homogeneous aluminium layer is deposited over both the etch resist layer and the final metallization surfaces,
- Finally, the etch resist layer is removed, resulting of the peel-off of the aluminium layer from the unwanted surface.

An additional step of applying pressure on the top exposed area of the structured aluminium layer can be implemented to deform plastically the structure and form nubs with negative slope on their top.

This embodiment can improve advantageously the tensile and the shear adhesive strength of the structure.

An example is shown on figure 9 and can consist in taking the structure with squares or waves shaped nubs as presented in figure 6 or figure 7, and bringing a pressure forming tool in contact with the top of the exposed area, and then applying a pressure using a flat tool to deform plastically the finally overhang structure. The peaks of the structure present finally a bulge shape at their top as shown in figure 9.

In an example, the tool can be controlled in displacement mode, such as the structure is only partially deformed, and to avoid forming a flat metallization or to not create closed porosity in the metallization. For example, the displacement of the tool can be limited by the presence of a stopper (as shown in the lateral sides of figure 9).

In addition to improving the adhesive strength in shear mode, such overhang structure can improve the adhesive strength in tensile mode when the metallization is brought in contact with a second material, i.e., when force is applied in the direction out of the plane of the metallization surface.

A part only of the metallization layer can be structured. For example, the structure shall not be applied in regions of the layer where wires are connected.

Thus, advantageously, the metallization improves the reliability of the interconnection with adjacent layers, and the reliability of the interconnection with wires is not compromised.

In figure 10 below, the regions where aluminium wirebonds are connected (using ultrasonic bonding process for example) are flat and not structured. Higher wirebond reliability is generally associated with bonding onto smooth surfaces, thus it is beneficial to exclude the structure in a region slightly larger than the wirebond surface, for example in regions of dimensions $1000\mu m \times 2000\mu m$ or $400\mu m \times 1000\mu m$, where it is known a priori that wires will be attached using the ultrasonic bonding process.

The present disclosure aims also at a power electronic module, containing one or several semiconductor chips, where at least one of the semiconductor chip(s) is encapsulated using an epoxy-based encapsulating compound.

Thus, the structure improves the bonding between the semiconductor chip and the epoxy-based encapsulating compound, and the reliability of the bond between the aluminium and the epoxy compound is improved.

For example, the epoxy-based encapsulating compound has good wetting properties with the aluminium metallization, and during the encapsulation process the epoxy-based encapsulating compound forms a conforming interface with the aluminium metallization structure by infiltration into the structure. The wetting properties of the encapsulating compound in relation with the aluminium metallization structure can be measured using a sessile drop technique, where the epoxy resin is placed in the liquid state in contact with the aluminium metallization, and a parameter such as the Young angle is measured in the liquid state, or after solidification as less than 90°, preferably less than 60°, preferably less than 30°. The Young angle standardly is defined as the angle made by the epoxy-gas surface with the metallization-epoxy surface.

The epoxy-based encapsulating compound is a material where a significant volume portion of the material consists in the epoxy resin, for example more than 20%, or more than 50%, the other constituents of the material being additives particles to confer the materials appropriate properties , such as a coefficient of thermal expansion in the range 5ppm/K to 30ppm/K, or a thermal conductivity better than that of pure epoxy resin. For example, aluminium oxide particles are mixed with the epoxy resin in a volume portion of more than 40%, or more than 70%.

During the encapsulation process, a pressure difference can be applied between the liquid encapsulant and one or several cavities of the power module, each of them forming a volume between:

- a substrate of the semiconductor chip (typically a combination of one or several ceramic isolation plates with metallic connection leads, possibly fixed to a copper plate), and

- A case or lid made of hard polymer material (possibly with power and control terminals to connect the semiconductor chips to external circuitries).

Thus, the epoxy-based encapsulant can better fill the structure, the process yield is higher, and the reliability of the bond between the aluminium and the epoxy compound is improved.

When the challenge of creating a conforming interface between the aluminium metallization and the epoxy encapsulant cannot be overcome solely by using an epoxy resin with good wetting properties (for example due to unacceptably high viscosity and thus processing time), the application of a pressure difference can be used to create an essentially pore-free, gas-free aluminium-epoxy interface.

The volume to be encapsulated can be essentially closed except for an input for the epoxy resin and vent holes to enable gas escape during the processing. The epoxy-based encapsulant is filled in the aforesaid volume and a pressure difference compared to the atmospheric pressure is applied at the epoxy inlet of the volume, for example +1 bar, or +10 bar, or + 100bar.

The volume to be encapsulated can be essentially closed except for an input for the epoxy resin and purge holes to pump out the gas prior to, or during the processing. The gas is first pumped out of the cavity such as a pressure sufficiently low is reached, for example 100mbar, or 10mbar, or 1mbar, and then, the epoxy-based encapsulant is filled in the volume.

Alternatively, in another example, several cycles of under pressure/ filling events are applied, the filling being done with an epoxy-based encapsulating compound pressure of +0bar (i.e. atmospheric pressure), or at a pressure above atmospheric pressure, as describe in a previous example.

Standard compression moulding process can also be used to apply a pressure on the epoxy-based encapsulant.

A copper metallization layer can be in contact with the structured aluminium metallization layer.

The copper-metal semiconductor interconnection stack is more reliable against thermomechanical fatigue because of the presence of an interlock structure, and the copper metal cannot diffuse into the semiconductor because of the diffusion barrier property of the aluminium metallization layer.

The minimum aluminium metallization thickness T-D/2 can be more than $2\mu m$, preferably more than $3\mu m$, preferably more than $5\mu m$, so that the aluminium metallization has a minimum thickness enough to work as a diffusion barrier against copper diffusion.

A thin ($<2\mu m$) interfacial layer can be present between the copper layer and the structured aluminium metallization, in order to provide one or several of the following properties: corrosion or reaction barrier between aluminium and copper, or oxidation resistance at the interface, good wetting properties between aluminium and copper during the copper deposition process. For example, such diffusion barrier may be Ti, TiN, Ta, TaN, Au, Ni, Pd, Ag, or any electrically conducting metal, and may be deposited using state of the art deposition processes such as, for example PVD, CVD, electroplating, electroless plating.

The average copper layer thickness can be between $5\mu m$ and $50\mu m$, preferably between $10\mu m$ and $30\mu m$.

The reliability of the assembly can be increased by a factor 2, preferably by a factor 10 (the reliability being evaluated using standard test procedures like AQG324).

The copper-metal-semiconductor interconnection can be deposited using a plating process comprising at least some of the following steps:

- 1/ prepare structured aluminium metallization layer, then,
- 2/ cleaning the surface using a degreaser, then,
- 3/ chemically attack the aluminium surface using an acid, then,
- 4/ activate the surface with one or several zincate bath treatments, then,
- 5/ optionally depositing one or several thin ($<2\mu m$) layers using an electroplating, or electroless plating, then,
- 6/ deposition of a copper layer using only an electroplating or electroless plating process, or a combination of an electroplating or electroless plating process followed by a PVD or a CVD process, then, optionally,
- 7/ flatten the copper surface using a mechanical, or chemical-mechanical polishing process.

For example, in step 2, the surface is cleaned using a degreaser as isopropanol and/or acetone and/or ethanol, and then rinse in demineralized water.

For example, in step 3, the surface is attacked using a solution containing nitric acid, and/or chloridric acid, and/or sodium difluoride and/or sulfuric acid and/or chromic acid, and/or hydrofluoric acid, so as to remove a surface layer, of less than $1\mu m$, preferably less than 100nm, and expose an aluminum surface free of oxides and foreign elements.

For example, in step 6, a thin seed layer of copper ($<2\mu m$) can be deposited using a PVD or a CVD technique, and the remaining part of the copper metallization material is deposited using a plating method (usually less expansive).

For example, in step 7, the non-flat copper surface is flattened using state of the art chemical mechanical polishing, such as attaching the bottom of the semiconductor on a first rotating surface, and/or bringing a second, abrasive rotating surface parallel to the first one in contact with the copper layer to remove excess copper material by mechanical abrasion, possibly aided by chemical action.

The resulting structure is shown on figure 11.

The embodiments presented above can be applied to technology areas requiring high adhesion strength between aluminium and other materials such as polymer materials or copper.

A general issue in component assembly is the poor adhesive strength between aluminium and such materials and for example epoxy resins typically. The main reasons are the fast oxidation of aluminium and the reduced adhesive strength between oxidized aluminium and oxide-free aluminium. The embodiments above permit to achieve improved adhesive strength between aluminium and epoxies for example, despite the presence of an oxide layer, and thus opens the possibility to assemble aluminium parts using epoxy-based glues. Such application areas can be epoxy coatings for corrosion protection of aluminium, thermal-efficient aluminium heat sink assembly (to power modules for example), general electronics packaging, PCB assembly to aluminium, etc.

Other embodiments can be implemented to structure the aluminium surface prior to bonding. For example, structuring tools appropriate to the relevant technology area can be used. For example, structuring bulky aluminium surfaces (e.g., from a heat sink) using machining techniques may be more time and cost efficient than using lithography techniques.

Embodiments can further be adapted to the area of technologies where a low-cost, yet reliable interconnection between copper and an electronic device is required, and where copper can poison the semiconductor device (mainly Si and SiC devices). In general, copper may be preferred over aluminium to benefit from higher electrical conductivity and lower thermal expansion coefficient. For example, such application area can be in the field of photovoltaic solar cells (currently using screen-printed aluminium back surface metallization), Si and/or SiC power modules (for traction, factory automation, automotive, industrial drives, embedded drives, charging stations, solar inverters, etc.), general electronic devices, or others.

**Claims**

1. A semiconductor chip, having an aluminium layer, wherein said aluminium layer has a structuration of at least a portion of a surface receiving an additional deposition, and wherein said structuration forms peaks on said portion of surface occupying between 20 and 80% of said portion of surface.

2. The semiconductor chip of claim 1, wherein said aluminium layer is a metallization layer having a mean thickness T between $2\mu m$ and $15\mu m$.

3. The semiconductor chip according to anyone of the precedent claims, wherein, the aluminium layer having a mean thickness T, the structuration has a length L, measuring a mean distance between first neighbour peaks of the structuration, and being related to said mean thickness T by $L<10*T$.

4. The semiconductor chip according to anyone of the precedent claims, wherein, the aluminium layer having a mean thickness T, the structuration has a depth D, measuring a mean depth D of said peaks, and being related to said mean thickness T by $D>0.2*T$.

5. The semiconductor chip according to anyone of the precedent claims, wherein said peaks form a periodic sinusoidal shape in at least one profile section of said structuration (FIG.7).

6. The semiconductor chip according to anyone of the precedent claims, wherein said peaks have a bulge at their top (FIG.9).

7. The semiconductor chip according to anyone of the precedent claims, wherein said semiconductor chip is a power semiconductor chip.

8. The semiconductor chip according to anyone of the precedent claims, wherein said surface of the aluminium layer comprises at least one additional portion distinct from said portion comprising the structuration, and configured for an electrical connection of said aluminium layer (FIG. 10).

9. The semiconductor chip according to anyone of the precedent claims, wherein said additional deposition comprises copper.

10. The semiconductor chip according to anyone of the claims 1 to 8, wherein said additional deposition comprises an epoxy resin.

11. A method for manufacturing a semiconductor chip having an aluminium layer, the method comprising:

   - depositing said aluminium layer,
   - forming a structuration on at least a portion of a top surface of said aluminium layer, and
   - forming an additional deposition at least on said portion,

   wherein said structuration forms peaks on said portion occupying between 20 and 80% of said portion.

12. The method according to claim 11, wherein forming said structuration comprises:

   - a spatially selective deposition of a mask on said portion, said mask avoiding an etching effect of the aluminium layer underneath the mask,
   - etching said portion, and
   - removing the mask.

**13.** The method according to anyone of claims 11 and 12, wherein forming said structuration comprises:

- a spatially selective deposition of a mask on said portion, said mask avoiding a deposition of aluminium on the mask,
- depositing aluminium on the portion, and
- removing the mask.

**14.** The method according to anyone of claims 11 to 13, wherein forming said structuration comprises a use of a machining tool to deform the top surface of said portion and create said peaks.

**15.** The method according to anyone of claims 11 to 14, wherein forming said structuration further comprises applying a pressing tool on said peaks tops to form bulges therein.

## FIG. 1

Encapsulating material ──→

Al wire ──→

Al metallization ──→

Semiconductor chip ──→

## FIG. 2

Encapsulating material ──→

Cu wire ──→

Cu metallization ──→
Diffusion barrier ──→

Semiconductor chip ──→

## FIG. 3

Encapsulating material

Cu wire

Cu metallization
Ag sinter layer
Al metallization

Thin interface layer

Semiconductor chip

Crack at Al-Cu interface (adhesive failure)

Cu metallization
Ag sinter layer
Al metallization layer
Semiconductor chip

Crack in Al material bulk (cohesive failure)

Crack in Cu material bulk (cohesive failure)

Cu metallization
Al metallization
Semiconductor chip

## FIG. 4

Crack at Al-Cu interface (adhesive failure)

Encapsulating polymer →

Al metallization layer →

Semiconductor chip →

Crack in Al material
bulk (cohesive failure)

Crack in Cu material
bulk (cohesive failure)

Encapsulating polymer →

Al metallization →

Semiconductor chip →

**FIG. 5**

Structured Al metallization →

Semiconductor chip →

L    D

T

R2
R1

**FIG. 6**

D

L

Structured Al metallization →

T

Semiconductor chip →

**FIG. 7**

FIG. 8

Structured Al
metallization →

Semiconductor chip →

Pressure forming tool →

Structured Al metallization →

Semiconductor chip →

P

Displacement
stopper

Structured Al metallization →

Semiconductor chip →

Displacement
stopper

FIG. 9

L ↕

FIG. 10

State of the art    Proposed solution

Cu

Al

Si or SiC

Cu

Al

Si or SiC

FIG. 11

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2021/205517 A1 (MITSUBISHI ELECTRIC CORP [JP]) 14 October 2021 (2021-10-14) | 1-4,7,9, 11,12 | INV. H01L23/485 |
| A | * paragraphs [0006], [0008], [0010] – [0012], [0022] – [0024], [0072] – [0088]; figures 1,10-12,14 * | 5,6,10, 14,15 | H01L23/31 ADD. H01L21/60 |
| X | JP 2005 019829 A (DENSO CORP) 20 January 2005 (2005-01-20) | 1-5,7,11 | |
| A | * paragraphs [0007], [0013] – [0016], [0021], [0024] – [0028], [0033] – [0038], [0046], [0047]; figures 1(a), 1(b), 2(a), 2(b), 2 (c) * | 6,9,10, 12,14,15 | |
| A | KENJI TOYOZAWA ET AL: "DEVELOPMENT OF COPPER WIRE BONDING APPLICATION TECHNOLOGY", IEEE TRANSACTIONS ON COMPONENTS, HYBRIDS AND MANUFACTURING TECHNOLOGY, IEEE INC. NEW YORK, US, vol. 13, no. 4, 1 December 1990 (1990-12-01), pages 667-672, XP000176811, ISSN: 0148-6411, DOI: 10.1109/33.62577 * the whole document * | 1-7, 9-12,14, 15 | |
| | | | TECHNICAL FIELDS SEARCHED (IPC) |
| | | | H01L |
| X | US 2006/081996 A1 (SHINYAMA KEIJI [JP] ET AL) 20 April 2006 (2006-04-20) | 1-4,6,7, 11 | |
| A | * paragraphs [0002], [0013] – [0016], [0025] – [0057], [0069]; figures 2B, 3A,3B * | 5,9,10, 12,14,15 | |
| X | US 2010/181688 A1 (YANAGISAWA HIROTOMO [JP] ET AL) 22 July 2010 (2010-07-22) | 1-4,6, 10-12 | |
| Y | * paragraphs [0005], [0007], [0015], [0034] – [0072]; figures 1,2,3,11,16 * | 14,15 | |
| A | | 5,7,9 | |

-/--

The present search report has been drawn up for all claims

| Place of search | Date of completion of the search | Examiner |
|---|---|---|
| Munich | 23 February 2023 | Ahlstedt, Mattias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**page 1 of 2**

Europäisches
Patentamt

European
Patent Office

Office européen
des brevets

## EUROPEAN SEARCH REPORT

Application Number

EP 22 30 5748

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | JP 2007 258587 A (ROHM CO LTD) 4 October 2007 (2007-10-04) | 14,15 | |
| A | * paragraphs [0025] – [0037]; figures 5-10 * | 1-7,9-12 | |
| | ----- | | |

TECHNICAL FIELDS
SEARCHED        (IPC)

The present search report has been drawn up for all claims

| Place of search | Date of completion of the search | Examiner |
|---|---|---|
| Munich | 23 February 2023 | Ahlstedt, Mattias |

EPO FORM 1503 03.82 (P04C01)

Europäisches
Patentamt
European
Patent Office
Office européen
des brevets

**Application Number**

EP 22 30 5748

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1-7, 9-12, 14, 15

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt
European
Patent Office
Office européen
des brevets

**LACK OF UNITY OF INVENTION**
**SHEET B**

Application Number

EP 22 30 5748

The Search Division considers that the present European patent application does not comply with the requirements of unity of invention and relates to several inventions or groups of inventions, namely:

1. claims: 1-5, 7, 9, 11, 12

   The subject matter of claim 5, directed to that said peaks form a periodic sinusoidal shape in at least one profile section of said structuration.
   ---

2. claims: 6, 15

   The corresponding subject matter of claims 6 and 15, directed to either that the said peaks have a bulge at their top, or the method of forming said structuration further comprises applying a pressing tool on said peaks tops to form bulges therein.
   ---

3. claim: 8

   The subject matter of claim 8, directed to that said surface of the aluminium layer comprises at least one additional portion distinct from said portion comprising the structuration, and configured for an electrical connection of said aluminium layer
   ---

4. claim: 10

   The subject matter of claim 10, directed to that said additional deposition comprises an epoxy resin.
   ---

5. claim: 13

   The subject matter of claim 13, directed to that forming said structuration comprises:- a spatially selective deposition of a mask on said portion, said mask avoiding a deposition of aluminium on the mask,- depositing aluminium on the portion, and- removing the mask.
   ---

6. claim: 14

   The subject matter of claim 14, directed to that forming said structuration comprises a use of a machining tool to deform the top surface of said portion and create said peaks.
   ---

**EP 4 280 273 A1**

## ANNEX TO THE EUROPEAN SEARCH REPORT
## ON EUROPEAN PATENT APPLICATION NO.

EP 22 30 5748

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2023

| Patent document cited in search report | | Publication date | Patent family member(s) | | Publication date |
|---|---|---|---|---|---|
| WO 2021205517 | A1 | 14-10-2021 | CN | 115315791 A | 08-11-2022 |
| | | | DE | 112020007026 T5 | 19-01-2023 |
| | | | JP | 6991402 B1 | 13-01-2022 |
| | | | JP | WO2021205517 A1 | 14-10-2021 |
| | | | US | 2023047789 A1 | 16-02-2023 |
| | | | WO | 2021205517 A1 | 14-10-2021 |
| JP 2005019829 | A | 20-01-2005 | JP | 3812549 B2 | 23-08-2006 |
| | | | JP | 2005019829 A | 20-01-2005 |
| US 2006081996 | A1 | 20-04-2006 | CN | 1763941 A | 26-04-2006 |
| | | | DE | 102005049575 A1 | 20-04-2006 |
| | | | JP | 4604641 B2 | 05-01-2011 |
| | | | JP | 2006114827 A | 27-04-2006 |
| | | | US | 2006081996 A1 | 20-04-2006 |
| US 2010181688 | A1 | 22-07-2010 | JP | 2010171107 A | 05-08-2010 |
| | | | US | 2010181688 A1 | 22-07-2010 |
| JP 2007258587 | A | 04-10-2007 | JP | 4657129 B2 | 23-03-2011 |
| | | | JP | 2007258587 A | 04-10-2007 |

EPO FORM P0459

For more details about this annex : see Official Journal of the European Patent Office, No. 12/82